# EUROPÄISCHE PATENTSCHRIFT

(11) **EP 0 690 567 B1**
(45) Veröffentlichungstag und Bekanntmachung des Hinweises auf die Patenterteilung: **15.12.2004**
(21) Anmeldenummer: 95107881.5
(22) Anmeldetag: 20.05.1995
(51) Int. Cl.: H03J 1/00, H04N 7/20

(54) **Verfahren und Anordnung zur automatischen Erkennung der Oszillatorfrequenz eines in der Ausseneinheit einer Satelliten-empfangsanlage angeordneten Frequenzumsetzers**
Method and arrangement for the automatic detection of the oscillator frequency of an outdoor unit of a satellite reception system
Procédé et montage pour la détermination automatique de la fréquence de l'oscillateur du convertisseur de fréquence, agence dans la partie extérieux d'un montage de réception pour satellite

(30) Priorität: 30.06.1994 DE 4422908
(43) Veröffentlichungstag der Anmeldung: 03.01.1996
(73) Patentinhaber: Grundig Multimedia B.V., 1083HJ Amsterdam (NL)
(72) Erfinder: Heider, Peter, Grundig E.M.V., D-90762 Fürth (DE)
(74) Vertreter: Pröll, Jürgen

(56) Entgegenhaltungen:
- EP-A- 0 483 463
- EP-A- 0 505 038
- EP-A- 0 601 553
- DE-A- 3 242 430
- DE-A- 3 801 524
- FUNKSCHAU, Bd. 63, Nr. 19, 6.September 1991, Seiten 58-60, XP000261114 "SENDER AUTOMATISCH ERFASST"

## Beschreibung

Die Erfindung betrifft ein Verfahren und eine Anordnung zur automatichen Erkennung der Oszillatorfrequenz eines Frequenzumsetzers einer Satelliten-Empfangsanlage.

Aus der DE-C2 38 01 524 ist ein Fernsehempfänger bekannt, der sich wahlweise auf Antennenkanäle oder Kabelkanäle abstimmen läßt. Wenn der Benutzer bei diesem bekannten Fernsehempfänger zur Speicherung der empfangbaren Sender die Taste für die automatische Senderprogrammierung betätigt, so wird derTuner zunächst veranlaßt, in der Kabel-Abstimmbetriebsart zu arbeiten, wobei die Abstimmung nacheinander auf die Kanäle einer vorbestimmten Testgruppe von Kabelkanälen erfolgt. Existieren gültige Signale für eine vorbestimmte Anzahl von Kanälen, so wird der Empfänger in der Kabelbetriebsart gehalten und ein Autoprogrammierungsvorgang eingeleitet, um die Kanallisten eines Speichers mit allen empfangbaren Kabelkanälen zu programmieren. Wird hingegen in der vorbestimmten Testgruppe das vorbestimmte Empfangskriterium nicht erfüllt, dann wird der Empfänger veranlaßt, in die Abstimmbetriebsart für den Antennenempfang umzuschalten.

Aus der DE-A1 32 42 430 ist ein Verfahren zur Abstimmung eines AM-Empfängers bekannt, bei welchem eine automatische Abstimmung auf Sender erfolgen soll, deren Sendefrequenzen unterschiedliche Frequenzraster aufweisen. Dazu wird beim Empfang einer Frequenz in einem Frequenzraster der Pegel des Empfangssignals gemessen und mit dem Pegel des Empfangssignals mit einer Frequenz des zweiten Frequenzrasters verglichen. Danach wird der Empfänger auf die Frequenz abgestimmt, die den höheren Signalpegel liefert.

Ein Satellitenempfänger hat die Aufgabe, von der Außeneinheit einer Satellitenempfangsanlage zur Verfügung gestellte Satellitenfernsehsignale, die in einem Frequenzbereich von 910 bis 2050 MHz liegen, in eine Form umzuwandeln, die jedes herkömmliche Fernsehgerät und jeder herkömmliche Videorecorder verarbeiten kann, beispielsweise in ein FBAS-Signal, welches an einer Euro-AV-Buchse des Satellitenempfängers zur Verfügung gestellt wird, oder in ein im UHF-Bereich liegende Signal, welches an einer Antennenbuchse des Satellitenempfängers ausgegeben wird. Weiterhin ist es auch möglich, den Satellitenempfänger in ein gemeinsames Gehäuse mit einem Fernsehempfänger oder einem Videorecorder einzubauen.

Da zum einen die Anzahl der Satelliten, die Fernsehprogramme abstrahlen, immer größer wird und zum anderen die Anzahl der Satellitenparameter, die notwendig sind, um eine Satellitenempfangsanlage zum Empfang eines bestimmten Programmes einzustellen, ebenfalls groß ist, werden bei neueren Satellitenempfängern die zur Senderprogrammierung des Satellitenempfängers notwendigen Satellitenparameter bereits werksseitig in einem Speicher des Satellitenempfängers abgespeichert. Diese Satellitenparameter werden dem Benutzer bei der Empfängerprogrammierung zur Auswahl bzw. Übernahme in den Satellitensenderspeicher des Empfängers auf einem Bildschirm zur Verfügung gestellt.

Weiterhin ist es bei der Empfängerprogrammierung notwendig, den Empfänger im Rahmen einer sogenannten Grundeinstellung an die am Empfangsort vorhandene Außeneinheit anzupassen. Dies geschieht bei der aus der EP-A-0 483 463 bekannten Vorrichtung im Rahmen eines Dialoges, bei welchem der Benutzer mittels auf dem Bildschirm alphanumerisch dargestellter Fragen zur Eingabe bestimmter Informationen, beispielsweise der Oszillatorfrequenz des Frequenzumsetzers in der Außeneinheit, aufgefordert wird.

Ausgehend von diesem Stand der Technik liegt der Erfindung die Aufgabe zugrunde, einen Weg aufzuzeigen, wie die Anpassung eines Satellitenempfängers an eine am Empfangsort vorhandene Außeneinheit vereinfacht werden kann.

Diese Aufgabe wird durch ein Verfahren mit den im Anspruch 1 bzw. eine Anordnung mit den im Anspruch 7 angegebenen Merkmalen gelöst. Vorteilhafte Weiterbildungen ergeben sich aus den abhängigen Ansprüchen.

Die Vorteile der Erfindung bestehen insbesondere darin, daß die Einstellung der notwendigen Oszillatorfrequenz des Frequenzumsetzers unter Zuhilfenahme von in einem Speicher abgespeicherten Empfangsparametern und verschiedenen in Frage kommenden Oszillatorfrequenzen automatisch erfolgt, so daß der Benutzer die jeweils notwendige Oszillatorfrequenz nicht kennen muß. Weiterhin werden durch die automatische Einstellung der notwendigen Oszillatorfrequenz eventuelle Bedienungsfehler, wie sie bei bekannten Satellitenempfängern bei der manuellen Eingabe der Oszillatorfrequenz auftreten können, grundsätzlich vermieden.

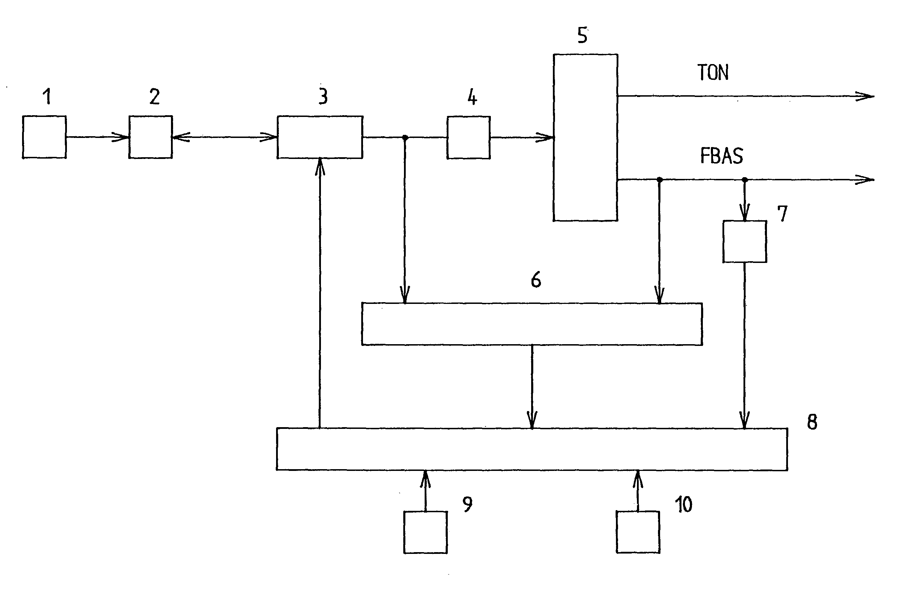

Weitere Vorteile der Erfindung ergeben sich aus der Erläuterung eines Ausführungsbeispiels anhand der Figur, die die zum Verständnis der Erfindung notwendigen Bauteile einer Satellitenempfangsanlage zeigt.

Im einzelnen handelt es sich dabei um eine Außeneinheit mit einer Satellitenantenne 1 und einer rauscharmen Frequenzumsetzereinheit 2 (LNC) und eine Inneneinheit (Satellitenempfänger) mit einem Satellitentuner 3, einem Mischer 4, einer Signalverarbeitungsschaltung 5, einer Qualitätsauswertungsschaltung 6, einer Videotextsignalauswerteschaltung 7, einem Mikrocomputer 8, einer ersten Speichereinheit 9 und einer zweiten Speichereinheit 10.

Die Satellitenantenne 1 und die rauscharme Frequenzumsetzereinheit 2 sind am Empfangsort fest installiert. Die Satellitenantenne ist derart ausgerichtet, daß sie die von einem Satelliten ausgestrahlten Satellitenfernsehsignale, beispielsweise Signale des Satelliten ASTRA, optimal empfangen kann. Die rauscharme Frequenzumsetzereinheit 2 besteht aus einem rauscharmen Vorverstärker, einem Spiegelfrequenzfilter, einem Mischer, einem Oszillator zur Erzeugung von Mischsignalen und einem selektiven Verstärker.

Beim Satellitenempfänger handelt es sich um einen Fernsehempfänger mit integriertem Satellitenempfangsteil, einen Videorecorder mit integriertem Satellitenempfangsteil, einem Satellitenreceiver als eigenständiges Gerät oder um ein Satellitenempfangsteil, welches zur Nachrüstung eines Fernsehempfängers oder Videorecorders vorgesehen ist. Beim Mikrocomputer 8 kann es sich um einen Mikrocomputer handeln, der Bestandteil des Satellitenempfangsteils ist oder um den Mikrocomputer des Fernsehempfängers oder Videorecorders, wenn ein Fernsehempfänger oder Videorecorder mit integriertem Satellitenempfangsteil vorliegt. In den Speichereinheiten 9 und 10 des Satellitenempfängers, die zur Veranschaulichung als getrennte Speicher gezeichnet sind, sind bereits werksseitig Daten abgespeichert, um dem Benutzer die Inbetriebnahme des Satellitenempfängers zu erleichtern. In der Speichereinheit 9 sind mehrere vorgegebene Oszillatorfrequenzen abgespeichert, die für die rauscharme Frequenzumsetzereinheit in Frage kommen, beispielsweise 9,75 GHz, 10 GHz, 10,75 GHz und 11 GHz. Alternativ dazu können in der Speichereinheit 9 auch Oszillatorfrequenzen abgespeichert sein, die einen vorgegebenen Frequenzabstand voneinander haben und ein vorgegebenes Frequenzintervall abdecken. Beispielsweise kann das Frequenzintervall von 9 - 11 GHz reichen und der Frequenzabstand 10 MHz betragen.

In der Speichereinheit 10 sind für eine Vielzahl von Satellitensendern die zur Senderprogrammierung des Satellitenempfängers notwendigen Satellitenparameter abgespeichert. Im einzelnen handelt es sich dabei um die Frequenz bzw. Kanalnummer, die Polarisationsrichtung, den Videohub, die Videomodulation, die ZF-Bandbreite, die Audiofrequenzen, den Audiomodus und den Sendernamen.

Der Mikrocomputer 8 ist derart programmiert, daß er nach Eingabe eines Initialisierungsbefehls oder automatisch bei der ersten Inbetriebnahme des Satellitenempfängers einen ersten Satellitensender auswählt, dessen Parameter in der Speichereinheit 10 abgespeichert sind. Weiterhin liest der Mikrocomputer 8 aus der Speichereinheit 9 eine vorgegebene Oszillatorfrequenz aus. Die genannten Parameter und die Oszillatorfrequenz, die die Signalverarbeitung im Satellitentuner 3 beeinflussen, werden dem Satellitentuner 3 zugeführt. Die Information über die Polarität wird vom Satellitentuner an die Außeneinheit weitergeleitet, um dort bei Bedarf eine Polarizerumschaltung auszulösen.

Das Ausgangssignal des Satellitentuners 3 wird in grundsätzlich bekannter Weise über einen Mischer 4 und eine Signalverarbeitungsschaltung 5 geleitet. Am Ausgang der Signalverarbeitungsschaltung 5 stehen das Tonsignal und ein FBAS-Signal zur Verfügung, welche beispielsweise an eine nicht gezeichnete Euro-AV-Buchse des Satellitenempfängers weitergeleitet werden.

Weiterhin wird das Ausgangssignal des Satellitentuners 3 einer Schaltung 6 zur Qualitätsauswertung zugeführt. In dieser Schaltung wird überprüft, ob der Pegel des Ausgangssignals des Satellitentuners 3 größer ist als ein vorgegebener Referenzwert oder nicht.

Alternativ dazu oder zusätzlich dazu kann der Schaltung 6 zur Qualitätsauswertung auch das am Ausgang der Signalverarbeitungsschaltung 5 vorliegende FBAS-Signal zugeführt werden. Die Qualitätsbeurteilung kann dabei auch durch Auswertung der Bitfehlerrate eines in den Austastlücken des FBAS-Signals übertragenen Videotextsignals erfolgen.

Weiterhin wird zur Erhöhung der Auswertesicherheit das am Ausgang der Signalverarbeitungsschaltung 5 zur Verfügung stehende FBAS-Signal auch über eine Videotextsignalauswerteschaltung 7 geführt, mittels welcher aus dem Videotextsignal Signale extrahiert werden, die dem Sendernamen entsprechen. Diese Signale werden dem Mikrocomputer 8 zugeführt und dort mit Signalen verglichen, die ebenfalls dem Sendernamen entsprechen und der Speichereinheit 10 entnommen sind.

Anhand der Ausgangssignale der Schaltung 6 zur Qualitätsauswertung und der Videotextsignalauswerteschaltung 7 wird mittels des Mikrocomputers 8 eine Entscheidung getroffen, ob der jeweilige Sender gut empfangbar ist oder nicht.

Diese vorstehend beschriebene Untersuchung wird für beispielsweise 4 weitere Satellitensender wiederholt.

Führen mindestens 4 der genannten 5 Untersuchungen zu dem Ergebnis, daß der jeweilige Sender gut empfangbar ist, dann wird die erste vorgegebene Oszillatorfrequenz als die Richtige erkannt und in einen nicht gezeichneten Speicher übernommen, so daß sie für den weiteren Betrieb des Satellitenempfängers zur Verfügung steht.

Führen die genannten Untersuchungen hingegen zu dem Ergebnis, daß die erste vorgegebene Oszillatorfrequenz nicht der in der Außeneinheit verwendeten Oszillatorfrequenz entspricht, dann liest der Mikrocomputer 8 eine zweite der vorgegebenen Oszillatorfrequenzen aus der Speichereinheit 9 aus, um das oben beschriebene Verfahren unter Verwendung der vorgegebenen zweiten Oszillatorfrequenz für die 5 ausgewählten Satellitensender zu wiederholen. Wird die zweite vorgegebene Oszillatorfrequenz als die Richtige erkannt, wird sie in den genannten Speicher übernommen. Ist das nicht der Fall, dann wird das Verfahren mittels der weiteren vorgegebenen Oszillatorfrequenzen solange wiederholt, bis die richtige Oszillatorfrequenz gefunden ist oder solange, bis die Untersuchungen für alle vorgegebenen Oszillatorfrequenzen durchgeführt wurden. Im letzteren Fall kann nach dem Ende der Auswertungen mittels eines OSD-Bausteins (on-screen-display) eine entsprechende Klartextmeldung auf einem Bildschirm dargestellt werden.

Beim vorstehend beschriebenen Verfahren braucht der Benutzer die im Frequenzumsetzer der Außeneinheit verwendete Oszillatorfrequenz nicht zu kennen und auch nicht mittels der Bedientastatur des Satellitenempfängers einzugeben. Dies bedeutet insbesondere für ungeübte Benutzer eine wesentliche Vereinfachung bei der Inbetriebnahme des Satellitenempfängers.

Die oben beschriebene Extraktion des Sendernamens mittels der Videotextauswerteschaltung 7 kann im späteren Betrieb des Satellitenempfängers dazu verwendet werden, zu erkennen, ob sich die Senderbelegung geändert hat oder nicht. Wird eine Änderung der Senderbelegung erkannt, dann kann der Satellitensenderspeicher automatisch aktualisiert und der Benutzer mittels einer Klartextanzeige am Bildschirm darüber informiert werden.

## Patentansprüche

1. Verfahren zur automatischen Erkennung der Oszillatorfrequenz eines in der Außeneinheit einer Satelliten-Empfangsanlage angeordneten Frequenzumsetzers mit folgenden Verfahrensschritten:
a) Auswahl vorprogrammierter Empfangsparameter einer vorbestimmten Anzahl von Satellitensendern,
b) Auswahl einer von mehreren vorgegebenen Oszillatorfrequenzen,
c) Abstimmen des Tuners der Satelliten-Empfangsanlage auf jeden der ausgewählten Satellitensender unter Verwendung der ausgewählten Oszillatorfrequenz,
d) Messung der Empfangsqualität jedes der ausgewählten Satellitensender,
e) Speicherung der Oszillatorfrequenz, wenn die gemessene Empfangsqualität ein vorgegebenes Gütekriterium erfüllt,
f) Auswahl einer weiteren der vorgegebenen Oszillatorfrequenzen, wenn das vorgegebene Gütekriterium nicht erfüllt ist,
g) Wiederholung der Schritte c, d, e und f solange, bis die gemessene Empfangsqualität das vorgegebene Gütekriterium erfüllt oder die Schnitte c, d und e für alle vorgegebenen Oszillatorfrequenzen durchgeführt sind.

2. Verfahren nach Anspruch 1,
**dadurch gekennzeichnet, daß** vorgegebene Oszillatorfrequenzen 9,75 GHz und 10 GHz sind.

3. Verfahren nach Anspruch 1 oder 2,
**dadurch gekennzeichnet, daß** die vorgegebenen Oszillatorfrequenzen einen vorgegebenen Frequenzabstand voneinander haben und ein vorgegebenes Frequenzintervall abdecken.

4. Verfahren nach einem oder mehreren der Ansprüche 1 - 3,
**dadurch gekennzeichnet, daß** zur Messung der Empfangsqualität der Pegel des Ausgangssignals des Tuners ausgewertet wird.

5. Verfahren nach einem oder mehreren der Ansprüche 1 - 4,
**dadurch gekennzeichnet, daß** zur Bestimmung der Empfangsqualität eine Messung der Bitfehlerrate eines zusammen mit dem Satellitenfernsehsignal übertragenen digitalen Signals erfolgt.

6. Verfahren nach einem oder mehreren der Ansprüche 1 - 5,
**dadurch gekennzeichnet, daß** ein vorprogrammierter Empfangsparamter der Name des Satellitensenders ist und daß ein Vergleich dieses Namens mit einem aus dem empfangenen Signal abgeleiteten Sendernamen erfolgt.

7. Anordnung zur automatischen Erkennung der Oszillatorfrequenz eines in der Außeneinheit einer Satelliten-Empfangsanlage angeordneten Frequenzumsetzers, mit
- einem Satellitentuner (3),
- einem mit dem Ausgang des Satellitentuners verbundenen Mischer (4),
- einer mit dem Ausgang des Mischers (4) verbundenen Signalverarbeitungsschaltung (5),
- einem Mikrocomputer (8), und
- einer ersten Speichereinheit (10) zur Abspeicherung von Satellitensender-Empfangsparametern.
**dadurch gekennzeichnet, daß**
- sie weiterhin eine zweite Speichereinheit (9) zur Abspeicherung mehrerer ausgewählter Oszillatorfrequenzen aufweist,
- der Mikrocomputer (8) derart programmiert ist, daß er zur Überprüfung der Empfangsqualität mehrerer Satellitensender die jeweils zugehörigen Satellitensender-Empfangsparameter aus der ersten Speichereinheit (10) und eine der Oszillatorfrequenzen aus der zweiten Speichereinheit (9) ausliest und dem Satellitentuner (3) zuführt, und
- eine an den Ausgang des Satellitentuners (3) und/oder den Ausgang der Signalverarbeitungsschaltung (5) angeschlossene Schaltung (6) zur Messung der Empfangsqualität vorgesehen ist, deren Ausgangssignal dem Mikrocomputer zugeführt wird.

8. Anordnung nach Anspruch 7,
**dadurch gekennzeichnet, daß** sie eine Videotextauswerteschaltung (7), an deren Ausgang Signale zur Verfügung stehen, die einem Sendernamen entsprechen, und eine Vergleichsschaltung (8) aufweist, in der diese Signale mit Signalen verglichen werden, die ebenfalls einem Sendernamen entsprechen und aus der ersten Speichereinheit (10) abgeleitet sind.

## Claims

1. Method of automatically detecting the oscillator frequency of a frequency converter disposed in the outdoor unit of a satellite receiving system, comprising the following method steps:
a) selection of preprogrammed reception parameters of a predetermined number of satellite transmitters,
b) selection of one or more preset oscillator frequencies,
c) tuning of the tuner of the satellite receiving system to each of the selected satellite transmitters using the selected oscillator frequency,
d) measurement of the reception quality of each of the selected satellite transmitters,
e) storage of the oscillator frequency if the measured reception quality fulfils a preset quality criterion,
f) selection of another of the preset oscillator frequencies if the specified quality criterion is not fulfilled,
g) repetition of steps c, d, e and f until the measured reception quality fulfils the preset quality criterion or steps c, d, e have been performed for all the specified oscillator frequencies.

2. Method according to Claim 1, **characterized in that** the specified oscillator frequencies are 9.75 GHz and 10 GHz.

3. Method according to Claim 1 or 2, **characterized in that** the specified oscillator frequencies have a specified frequency spacing from one another and cover a specified frequency interval.

4. Method according to one or more of Claims 1-3, **characterized in that**, to measure the reception quality, the level of the output signal of the tuner is evaluated.

5. Method according to one or more of Claims 1-4, **characterized in that**, to determine the reception quality, the bit failure rate is measured of a digital signal transmitted together with the satellite television signal.

6. Method according to one or more of Claims 1-5, **characterized in that** a preprogrammed reception parameter is the name of the satellite transmitter and **in that** said name is compared with a transmitter name derived from the received signal.

7. Arrangement for automatically detecting the oscillator frequency of a frequency converter disposed in the outdoor unit of a satellite receiving system, comprising
- a satellite tuner (3),
- a mixer (4) connected to the output of the satellite tuner,
- a signal processing circuit (5) connected to the output of the mixer (4),
- a micromputer (8), and
- a first memory unit (10) for storing satellite-transmitter reception parameters,
**characterized in that**
- it furthermore has a second memory unit (9) for storing a plurality of selected oscillator frequencies,
- the microcomputer (8) is programmed in such a way that, to check the reception quality of a plurality of satellite transmitters, it reads in each case the associated satellite transmitter reception parameters out of the first memory unit (10) and one of the oscillator frequencies out of the second memory unit (9) and routes them to the satellite tuner (3), and
- a circuit (6) for measuring the reception quality is provided that is connected to the output of the satellite tuner (3) and/or the output of the signal processing circuit (5) and whose output signal is routed to the microcomputer.

8. Arrangement according to Claim 7, **characterized in that** it has a teletext evaluation circuit (7) at whose output signals are available that correspond to a transmitter name and a comparator circuit (8) in which said signals are compared with signals that likewise correspond to a transmitter name and are derived from the first memory unit (10).

## Revendications

1. Procédé d'identification automatique de la fréquence d'oscillation d'un convertisseur de fréquence, qui est disposé dans l'unité extérieure d'une installation de réception de satellites, présentant les étapes opératoires suivantes consistant à:
a) sélectionner des paramètres de réception préalablement programmés d'un nombre prédéterminé d'émetteurs de satellites,
b) sélectionner l'une d'une pluralité de fréquences d'oscillation prédéterminées,
c) accorder le tuner de l'installation de réception de satellites sur chacun des émetteurs sélectionnés de satellites en utilisant la fréquence d'oscillation sélectionnée,
d) mesurer la qualité de réception de chacun des émetteurs de satellites sélectionnés,
e) mémoriser la fréquence d'oscillation lorsque la qualité de réception mesurée satisfait à un critère prédéterminé de qualité,
f) sélectionner une autre des fréquences d'oscillation prédéterminées lorsque le critère prédéterminé de qualité n'est pas satisfait,
g) répéter les étapes c, d, e et f jusqu'à ce que la qualité mesurée de réception satisfasse au critère prédéterminé de qualité ou que les étapes c, d et e soient exécutées pour toutes les fréquences d'oscillation prédéterminées.

2. Procédé selon la revendication 1, **caractérisé en ce que** des fréquences d'oscillation prédéterminées sont 9,75 GHz et 10 GHz.

3. Procédé selon la revendication 1 ou 2, **caractérisé en ce que** les fréquences d'oscillation prédéterminées sont séparées par un écart en fréquence prédéterminé et couvrent un intervalle prédéterminé de fréquences.

4. Procédé selon une ou plusieurs des revendications 1 à 3, **caractérisé en ce que** pour la mesure de la qualité de réception, on évalue le niveau du signal de sortie du tuner.

5. Procédé selon une ou plusieurs des revendications 1 à 4, **caractérisé en ce que** pour la détermination de la qualité de réception, on exécute une mesure du taux d'erreurs sur les bits d'un signal numérique transmis avec le signal de télévision transmis par satellite.

6. Procédé selon une ou plusieurs des revendications 1 à 5, **caractérisé en ce qu'**un paramètre de réception préalablement programmé est le nom de l'émetteur de satellite et qu'une comparaison de ce nom à un nom d'émetteur dérivé du signal reçu est exécutée.

7. Dispositif d'identification automatique de la fréquence d'oscillation d'un convertisseur de fréquence disposé dans l'unité extérieure d'une installation de réception de satellites, comprenant
- un tuner de satellite (3),
- un mélangeur (4) pour lire la sortie du signal de satellite,
- un circuit (5) de traitement de signaux relié à la sortie du mélangeur (4),
- un micro-ordinateur (8), et
- une première unité de mémoire (10) pour mémoriser des paramètres de réception d'émetteurs de satellites,
**caractérisé en ce que**
- il comporte en outre une seconde unité de mémoire (9) pour mémoriser plusieurs fréquences d'oscillation sélectionnées,
- le micro-ordinateur (8) est programmé de telle sorte que pour le contrôle de la qualité de réception de plusieurs émetteurs de satellites, il lit les paramètres d'entrée respectivement associés d'émetteurs de satellites à partir de la première unité de mémoire (10) et l'une des fréquences d'oscillation à partir de la seconde unité de mémoire (9) et les envoie au tuner de satellite (3), et
- il est prévu un circuit (6) connecté à la sortie du tuner de satellite (3) et/ou à la sortie du circuit (5) de traitement de signaux et dont le signal de sortie est envoyé au micro-ordinateur.

8. Dispositif selon la revendication 7, **caractérisé en ce qu'**il comporte un circuit (7) d'évaluation de vidéotexte, à la sortie duquel sont disponibles des signaux, qui correspondent à un nom d'émetteur, et un circuit de comparaison (8), dans lequel ces signaux sont comparés à des signaux qui correspondent également à un nom d'émetteur et sont tirés de la première unité de mémoire (10).
